# EUROPEAN PATENT SPECIFICATION

(11) **EP 4 290 556 B1**
(45) Date of publication and mention of the grant of the patent: **16.07.2025**
(21) Application number: 21946847.7
(22) Date of filing: 09.12.2021
(51) Int. Cl.: H01L 21/311, C30B 29/30, C30B 33/08, H10N 30/082

(54) **METHOD FOR DRY-ETCHING LITHIUM NIOBATE**
VERFAHREN ZUM TROCKENÄTZEN VON LITHIUMNIOBAT
PROCÉDÉ DE GRAVURE À SEC DE NIOBATE DE LITHIUM

(30) Priority: 23.06.2021 CN 202110697917
(43) Date of publication of application: 13.12.2023
(73) Proprietor: Jiangsu Leuven Instruments Co. Ltd, Xuzhou, Jiangsu 221300 (CN)
(72) Inventor: FENG, Yingxiong, Xuzhou, Jiangsu 221300 (CN); DAI, Haicheng, Xuzhou, Jiangsu 221300 (CN); LIU, Jian, Xuzhou, Jiangsu 221300 (CN); CHE, Dongchen, Xuzhou, Jiangsu 221300 (CN); PENG, Taiyan, Xuzhou, Jiangsu 221300 (CN); XU, Kaidong, Xuzhou, Jiangsu 221300 (CN)
(74) Representative: HGF
(86) International application number: PCT/CN2021/136779
(87) International publication number: WO 2022/267373

(56) References cited:
- CN-A- 110 211 922
- CN-A- 110 211 922
- CN-A- 110 364 441
- CN-A- 110 364 441
- JP-A- 2008 044 243
- JP-A- H06 151 383
- US-B1- 9 484 216
- YAO YANQING ET AL: "Research Development on LiNbO3 Dry Etching", MICRONANOELECTRONIC TECHNOLOGY, vol. 49, no. 3, 31 March 2012 (2012-03-31), CN, pages 197 - 207, XP093016154, ISSN: 1671-4776, DOI: 10.3969/j.issn.1671-4776.2012.03.011
- YAO YANQING, LI JINYANG,WU JIANJIE,CHEN FANG,QI ZHIMEI: "Research Development on LiNbO3 Dry Etching", MICRONANOELECTRONIC TECHNOLOGY, WEI-NA DIANZI JISHU JOURNAL PRESS, CN, vol. 49, no. 3, 31 March 2012 (2012-03-31), CN , pages 197 - 207, XP093016154, ISSN: 1671-4776, DOI: 10.3969/j.issn.1671-4776.2012.03.011

## Description

### TECHNICAL FIELD

The present disclosure relates to the field of semiconductor processing, especially to a method for dry-etching lithium niobate.

### BACKGROUND

Lithium Niobate (LN) crystals are ferroelectrics having an oxygen octahedral structure, which integrates the piezoelectric, electrooptical, acousto-optic, nonlinear optical properties and photorefractive effects, and has extensive applications in the fields such as optical modulation, optical amplification, optical switch, optical storage and optical waveguide, so that LN crystals are one of the artificial crystals with the most optical properties and best comprehensive index. With the development of integrated optics, the requirements on the performance and the integration level of devices are continuously increased, and more requirements are also put forward on the etching process of LN.

The dry etching is a process for forming volatile substances or directly bombarding the surface of a sample to enable the sample to be etched by utilizing the action of atoms and molecules in a plasma state on the surface of the material. The dry etching can implement anisotropic etching, namely the longitudinal etching rate is far greater than the transverse etching rate, so that the fidelity of a fine pattern after transfer is ensured. Inductively Coupled Plasma (ICP) etching technology in dry etching is increasingly applied to the manufacturing of semiconductor devices due to the advantages such as high control precision, good largearea etching uniformity, less pollution.

However, LN is an extremely difficult material to be etched. Traditionally, ICP is used to etch LN, typically a combination of fluorine-based gases (e.g., CF₄, CHF₃, SF₆) and inert gases (e.g., Ar) is chose to be used to etch LN. For chlorine-based gases such as Cl₂, which are commonly used in dry etching, there are rare descriptions in literature and patents for etching LN. Nb element in LN reacts with F ion chemically, generating easily volatile NBF₃, NBF₄ and NBF₅; Li in the lithium niobate reacts with F ions to generate LiF which is not easy to volatilize and deposits on the etched surface, thereby reducing the etching rate and increasing the roughness on the etched surface. The ion bombardment of Ar gas can remove LiF sediment, increase the physical action in the etching reaction, improve the etching rate and improve the smoothness on the etched surface.

LN has a relatively slow etching rate, and in order to obtain a relatively deep etching depth, a metal film layer which is resistant to etching under F-based gas, such as Cr, Cu and Al, is currently selected as a mask. However, the metal film needs special equipment for manufacturing, the manufacturing process is complicated, the cost is relatively high, and the metal film is difficult to be removed after etching; in the process of forming a pattern by a lift-off process, metal can damage an LN crystal wafer, so that the wafer is subjected to dark cracking to influence the subsequent process; after the metal mask forms a pattern, vertical stripes currently exist on the side wall, and the stripes are brought to the etched LN side wall by dry etching, so that the smoothness on the etched LN side wall is insufficient.
Documents CN 110 364 441 A, YAO YANQING ET AL: "Research Development on LiNbO3 Dry Etching", MICRONANOELECTRONIC TECHNOLOGY, vol. 49, no. 3, 31 March 2012, pages 197-207, and CN 110 211 922 A relate to methods of etching lithium niobate.
Document JP H06 151383 A relates to a method of etching PLZT.

### SUMMARY

The invention is defined in appended claim 1, with dependent claims defining additional features.

In one embodiment, in the etching gas in Step 2, H₂ accounts for 20%-80% of the total gas flow.

In one embodiment, in the etching gas in Step 2, Cl₂ accounts for 5%-60% of the total gas flow.

In one embodiment, an upper radio frequency power of the etching machine during the etching ranges from 200 w to 1200 w and a lower radio frequency power ranges from 30 w to 600 w.

In one embodiment, a cavity pressure of the etching machine in the etching is less than 20 mT.

In one embodiment, a temperature of cooling liquid of the etching machine in the etching process ranges from 0 °C to 80 °C.

The beneficial effects are as follows.

A method for dry-etching lithium niobate is adopted in the present disclosure and the adopted gas is Cl₂/H₂ to etch lithium niobate, which is different from the traditional fluorine-based etching lithium niobate system. The present disclosure uses a dielectric material or photoresist as a mask, which not only optimizes the production flow, but also greatly improves productivity and saves cost after being applied to the production line.

Because the method for dry-etching lithium niobate is adopted in the present disclosure, the traditional photoresist mask or dielectric materials such as SiO, SiN, Si can be used as the hard mask in the dry-etching lithium niobate, and a better selection ratio and good morphology are obtained.

Because the method for dry-etching lithium niobate is adopted in the present disclosure, the lithium niobate has a high selection ratio to the mask, so the thickness of the dielectric mask or the photoresist mask can be made thinner, and the patterning process and the removing process of the mask are simplified.

In a traditional production line, metal masks such as Cr, Al, Cu are currently used for etching lithium niobate. There are many disadvantages in using metal masks to etch LN.

The metal mask adopted by the prior art has a complex manufacturing process and a relatively high cost; special equipment is required in the metal mask deposition, and photoetching is firstly required in the metal mask patterning, and then a complex procedure is adopted to transfer the pattern to the metal film layer. Whereas, the photoresist mask adopted by the method for dry-etching lithium niobate of the present disclosure forms a pattern through a photolithography process; the deposition cost of the dielectric mask is low, the dielectric mask deposition is easy to be patterned, and the patterning can be even completed in the same etching cavity with the dry-etching step.

The metal mask adopted in the prior art is difficult to be removed after etching, and the removing cost is high. Whereas, the dielectric and the photoresist adopted by the method for dry-etching the lithium niobate of the present disclosure are easy to be removed after dry-etching, the removing cost is low, and the method is mature; the mask removing process can even be carried out without breaking vacuum after etching.

For the lithium niobate crystal wafer, in the metal mask deposition and patterning process, the lithium niobate crystal is easily damaged by related processes, causing crystal hiddent cracks. The method for dry-etching lithium niobate adopted by the present disclosure can avoid the hiddent cracks by using the dielectric mask or the photoresist mask.

The method for dry-etching lithium niobate adopted by the present disclosure is an effective way for reducing the cost and simplifying the flow for the process of the lithium niobate device; the method has the potential to become a new process route in the production line, greatly saves the production cost and improves the productivity.

### BRIEF DESCRIPTION OF THE DRAWINGS

FIG. 1 illustrates a schematic diagram of the etching result 1 of a SiO mask LN crystal wafer in one embodiment of the present disclosure.
FIG. 2 illustrates a schematic diagram of the etching result 2 of the SiO mask LN crystal wafer in the embodiment as illustrated in FIG. 1.
FIG. 3 illustrates a schematic diagram of the etching result 1 of the PR mask LN crystal wafer in one embodiment of the present disclosure.
FIG. 4 illustrates a schematic diagram the etching result 2 of the PR mask LN crystal wafer in the embodiment as illustrated in FIG. 1.

### DETAILED DESCRIPTION OF THE EMBODIMENTS

In order to make the objectives and technical solutions of the embodiments of the present disclosure clearer, the technical solutions in the embodiments of the present disclosure will be clearly and completely described below with reference to the accompanying drawings in the embodiments of the present disclosure. It is apparent that the embodiments described are merely parts of embodiments in the present disclosure, and not all embodiments.

The basic principle of the method for dry-etching lithium niobate is as follows.

In the process of dry-etching lithium niobate, it is extremely important that the generated product can exist in a gaseous state under a vacuum condition and is pumped away; the boiling point of the Nb compound is generally low, and the Nb compound is easy to exist in a gaseous state and is pumped away under the high vacuum condition, so that the etching is not influenced; however, the compound of Li generally has a high boiling point, and is prone to forming a non-volatile deposition even under the condition of high vacuum, thereby blocking the etching, reducing the steepness on the side wall and causing the roughness on the side wall.

LiF is generated when lithium niobate is etched by traditional fluorine-based gas which has a boiling point of 1717 °C at the normal temperature. In the present disclosure, H₂, and Cl₂ undergo a chemical reaction with Li₂NbO₃, and the compound of LI includes LiH and LiCl; the boiling point of LiH at the normal temperature and pressure is 950 °C, and the boiling point of LiCl at the normal temperature and pressure is 1383 °C. Compared with LiF, LiH and LiCl have lower boiling points and are more volatile, the side wall inclination and the roughness caused by deposition are reduced, which is beneficial for obtaining a steep etching morphology and a smooth etched surface. In a traditional fluorine-based etched LN system, the steepness on the obtained side wall generally ranges from 60 degrees to 75 degrees; whereas in the system, the steepness on the side wall can be obtained greater than 80 degrees after etching LN.

The present disclosure adopts traditional PR mask or dielectric being SiO, SiN, or Si as the hard mask to etch LN, to obtain a better selection ratio and a good morphology, which is an effective way for reducing the cost and simplifying the flow for the LN process, and avoids the defects caused by using the metal mask to etch the LN, such as fussy manufacturing process, relative high cost, difficult removing, easy damage to LN crystal in lift-off process and easy roughness on LN side wall; meanwhile, the SiO and PR masks are easy to enable the side wall to be smooth, so that a smooth LN side wall can be obtained after etching.

The main etching gases used in the process of the present disclosure are Cl₂ and H₂, and an appropriate amount of inert gas is used as an auxiliary gas; the ME (Main Etch) step with stable parameters is used in the etching process. The upper radio frequency power ranges from 200 w to 1200 w, the lower radio frequency power ranges from 30 w to 600 w, the proportion of H₂ to the total gas flow ranges from 20% to 80%, the proportion of Cl₂ to the total gas flow ranges from 5% to 60%, the cavity pressure is less than 20 mT, and the temperature of the cooling liquid ranges from 0 °C to 80 °C during the process. When the etching material is crystal LN or thin film LN, with unlimited patterns and appropriate parameters, the etching process can obtain an ideal morphology, a faster etching rate and a higher selection ratio to masks.

### Example 1

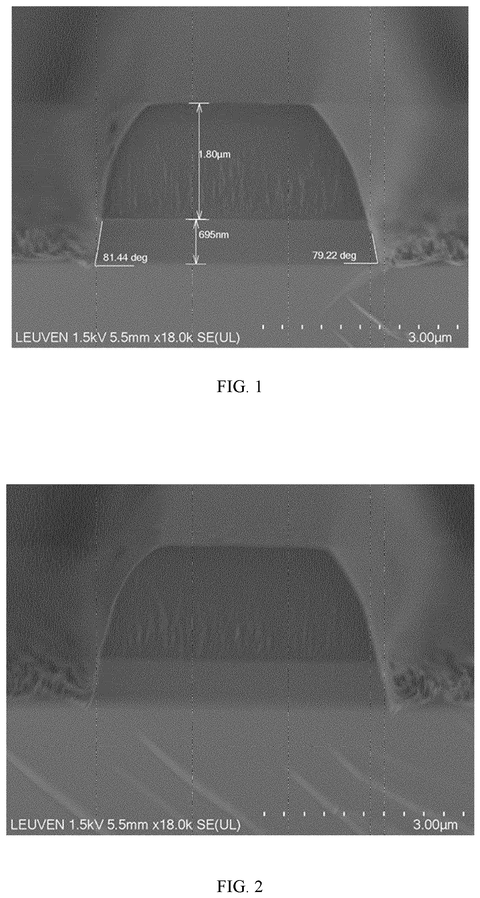

In this example as illustrated in FIG. 1 and FIG. 2, the etching machine used in the etching process is an inductively coupled plasma (ICP) etcher with a model number HAASRODE-E200. The used sample is LN crystal plate, the size is 1 cm*1 cm, the film structure is 2.1 µm SiO/500um Z-cut LN Sub, the SiO hard mask has completed the patterning process. The pattern is a line with a CD of approximately 3 µm.

The sample is transferred into the etcher chamber. Appropriate etching parameters are set, such as the upper radio frequency power is 600 w, the lower radio frequency power is 100 w, the cavity pressure is 5 mT, the process temperature is 20 °C, and the process ME time is 10 minutes; the mixed Cl₂, H₂ and Ar are introduced and ignited by radio frequency to start etching.

The sample is transferred into the etcher chamber. Appropriate etching parameters are set, such as the upper radio frequency power is 600 w, the lower radio frequency power is 100 w, the cavity pressure is 5 mT, the process temperature is 20 °C, and the process ME time is 10 minutes; and the mixed Cl₂, H₂ and Ar are introduced and ignited by radio frequency to start etching. After reaching the etching time, the etching is completed, and the etching time refers to the length of time required for the etching process. After the etching is completed, the sample is taken out and the etching morphology is checked using SEM cross-sectional photography.

With reference to FIGS. 1 and 2, according to the experimental results after etching, that is, ER=46.7nm/min, LN/SiO selection ratio is 1.57, the steepness is approximately 81 degrees, the side wall is smooth, and the bottom is rough, which is brought by the pre-etching value, hence, it can be seen that in the traditional fluorine-based etched LN system, the obtained side wall steepness is approximately 60 degrees to 75 degrees; whereas in the system, the steepness on the side wall can be obtained greater than 80 degrees after etching LN.

### Example 2

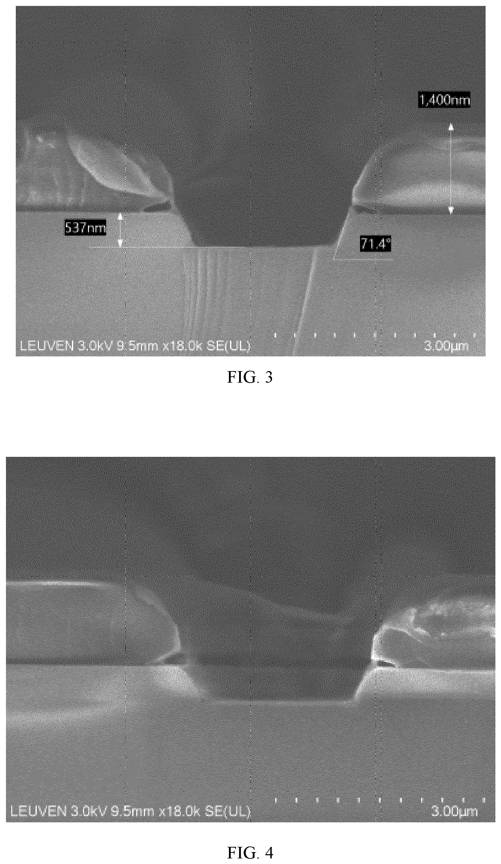

In Example 2 as illustrated in FIGS. 3 and 4, the etching machine used in the etching process is an inductively coupled plasma etcher with a model number HAASRODE-E200. The used sample is LN crystal plate, the size is 1 cm*1 cm, the film structure is 1.8 µm PR/500 um Z-cut LN Sub, the pattern is a trench with a CD of approximately 2 µm.

The sample is transferred into the etcher chamber. Appropriate etching parameters are set, such as the upper radio frequency power is 600 w, the lower radio frequency power is 80 w, the cavity pressure is 5 mT, the process temperature is 20 °C, and the process ME time is 10minutes; and the mixed Cl₂, H₂ and Ar are introduced and ignited by radio frequency to start etching. After the etching is completed, the sample is taken out and the etching morphology of the sample is checked using SEM cross-sectional photography.

ER=53.7nm/min, LN/PR selection ratio is 1.34, the steepness is approximately 71 degrees, the side walls and the bottom are smooth. According to the experimental results of the above two examples, the selection ratio of lithium niobate to dielectric material or photoresist during etching is approximately 1:1. In the traditional fluorine-based etched LN system, the obtained side wall steepness is approximately 60 degrees to 75 degrees; whereas in the system, the steepness on the side wall can be obtained greater than 80 degrees after etching LN. And the SiO mask and the PR mask are easy to enable the side wall to be smooth, the products in etching are more volatile compared with the traditional process, the deposition of the side wall is less, which is beneficial for obtaining the smooth side wall after etching.

The above descriptions are merely for the preferred embodiments of the present disclosure.

## Claims

1. A method for dry-etching lithium niobate comprising:
Step 1, putting patterned lithium niobate into an etching machine;
Step 2, introducing a mixed etching gas of Cl₂, H₂ and an inert gas into an etching cavity of the etching machine, and starting the etching machine by radio frequency ignition to start to etch; and
Step 3, completing the etching after etching time is reached, wherein
the lithium niobate in Step 1 is a lithium niobate wafer serving as a material to be etched, or a wafer made from a lithium niobate thin film grown above a substrate, and the lithium niobate thin film serves as a material to be etched, and either
wherein a SiO thin film or SiN thin film or Si thin film is adopted as a mask material during dry-etching in the lithium niobate wafer or the wafer containing a lithium niobate thin film, the mask material has been patterned; the SiO thin film or SiN thin film or Si thin film is a hard mask; or wherein
a photoresist is adopted as a mask material during dry-etching in the lithium niobate wafer or the wafer containing a lithium niobate thin film, the mask material has been patterned.

2. The method according to claim 1, wherein in the etching gas in Step 2, H₂ accounts for 20%-80% of a total gas flow.

3. The method according to claim 1, wherein in the etching gas in Step 2, Cl₂ accounts for 5%-60% of the total gas flow.

4. The method according to claim 1, wherein an upper radio frequency power of the etching machine during the etching ranges from 200 w to 1200 w and a lower radio frequency power ranges from 30 w to 600 w.

5. The method according to claim 1, wherein a cavity pressure of the etching machine in the etching is less than 20 mT.

6. The method according to claim 1, wherein a temperature of cooling liquid of the etching machine in the etching process ranges from 0 °C to 80 °C.

## Patentansprüche

1. Verfahren zum Trockenätzen von Lithiumniobat, umfassend:
Schritt 1, Einbringen von gemustertem Lithiumniobat in eine Ätzmaschine;
Schritt 2, Einleiten eines gemischten Ätzgases aus Cl₂, H₂ und einem Inertgas in einen Ätzhohlraum der Ätzmaschine und Starten der Ätzmaschine durch Hochfrequenzzündung, um mit dem Ätzen zu beginnen; und
Schritt 3, Abschließen des Ätzens nach Erreichen der Ätzzeit, wobei
das Lithiumniobat in Schritt 1 ein Lithiumniobat-Wafer ist, der als ein zu ätzendes Material dient, oder ein Wafer aus einem Lithiumniobat-Dünnfilm, der über einem Substrat gewachsen ist, ist und der Lithiumniobat-Dünnfilm als ein zu ätzendes Material dient, und entweder
wobei ein SiO-Dünnfilm oder SiN-Dünnfilm oder Si-Dünnfilm als ein Maskenmaterial während des Trockenätzens in dem Lithiumniobat-Wafer oder dem Wafer, der einen Lithiumniobat-Dünnfilm enthält, verwendet wird, das Maskenmaterial gemustert wurde; der SiO-Dünnfilm oder SiN-Dünnfilm oder Si-Dünnfilm eine Hartmaske ist; oder wobei
ein Fotolack als ein Maskenmaterial während des Trockenätzens in dem Lithiumniobat-Wafer oder dem Wafer, der einen Lithiumniobat-Dünnfilm enthält, verwendet wird, das Maskenmaterial gemustert wurde.

2. Verfahren nach Anspruch 1, wobei in dem Ätzgas in Schritt 2 H₂ 20 % - 80 % eines Gesamtgasstroms ausmacht.

3. Verfahren nach Anspruch 1, wobei in dem Ätzgas in Schritt 2 Cl₂ 5 % - 60 % des Gesamtgasstroms ausmacht.

4. Verfahren nach Anspruch 1, wobei eine obere Hochfrequenzleistung der Ätzmaschine während des Ätzens im Bereich von 200 W bis 1200 W liegt und eine untere Hochfrequenzleistung im Bereich von 30 W bis 600 W liegt.

5. Verfahren nach Anspruch 1, wobei ein Hohlraumdruck der Ätzmaschine beim Ätzen weniger als 20 mT beträgt.

6. Verfahren nach Anspruch 1, wobei eine Temperatur der Kühlflüssigkeit der Ätzmaschine in dem Ätzprozess im Bereich von 0 °C bis 80 °C liegt.

## Revendications

1. Procédé pour la gravure à sec de niobate de lithium comprenant :
Étape 1, le placement de niobate de lithium à motifs dans une machine de gravure ;
Étape 2, l'introduction d'un gaz de gravure mixte de Cl₂, H₂ et d'un gaz inerte dans une cavité de gravure de la machine de gravure, et le démarrage de la machine de gravure par allumage radiofréquence pour commencer à graver ; et
Étape 3, l'achèvement de la gravure une fois que le temps de gravure est atteint, dans lequel
le niobate de lithium à l'étape 1 est une plaquette de niobate de lithium servant de matériau à graver, ou une plaquette réalisée en un film mince de niobate de lithium développé au-dessus d'un substrat, et le film mince de niobate de lithium sert de matériau à graver, et soit
dans lequel un film mince de SiO ou un film mince de SiN ou un film mince de Si est adopté comme matériau de masque lors de la gravure à sec dans la plaquette de niobate de lithium ou la plaquette contenant un film mince de niobate de lithium, le matériau de masque ayant fait l'objet de formation de motifs ; le film mince de SiO ou le film mince de SiN ou le film mince de Si est un masque dur ; ou dans lequel
une résine photosensible est adoptée comme matériau de masque pendant la gravure à sec dans la plaquette de niobate de lithium ou la plaquette contenant un film mince de niobate de lithium, le matériau de masque ayant fait l'objet de formation de motifs.

2. Procédé selon la revendication 1, dans lequel dans le gaz de gravure à l'étape 2, H₂ représente 20 % à 80 % d'un flux de gaz total.

3. Procédé selon la revendication 1, dans lequel, dans le gaz de gravure à l'étape 2, Cl₂ représente 5 % à 60 % du flux de gaz total.

4. Procédé selon la revendication 1, dans lequel une puissance de radiofréquence supérieure de la machine de gravure pendant la gravure est comprise entre 200 w et 1200 w et une puissance de radiofréquence inférieure est comprise entre 30 w et 600 w.

5. Procédé selon la revendication 1, dans lequel une pression de cavité de la machine de gravure lors de la gravure est inférieure à 20 mT.

6. Procédé selon la revendication 1, dans lequel une température de liquide de refroidissement de la machine de gravure lors du processus de gravure est comprise entre 0 °C et 80 °C.
